# EUROPÄISCHE PATENTSCHRIFT

(11) **EP 1 505 734 B1**
(45) Veröffentlichungstag und Bekanntmachung des Hinweises auf die Patenterteilung: **17.12.2014**
(21) Anmeldenummer: 04018570.4
(22) Anmeldetag: 05.08.2004
(51) Int. Cl.: H03K 17/955, E05B 81/78, E05B 81/76

(54) **Kapazitiver Näherungsschalter**
Capacitive proximity switch
Commutateur de proximité capacitif

(30) Priorität: 08.08.2003 DE 10336335
(43) Veröffentlichungstag der Anmeldung: 09.02.2005
(73) Patentinhaber: ifm electronic gmbh, 45128 Essen (DE); Huf Hülsbeck & Fürst GmbH & Co. KG, 42551 Velbert (DE)
(72) Erfinder: Schulz, Jörg, 6890 Lustenau (AT); Heilig, Gerhard, 88289 Waldburg (DE); Richter, Heidrun, 86637 Wertingen (DE); Steegmann, Bernd, 42579 Heiligenhaus (DE); Witte, Martin, 48683 Ahaus (DE); Uselli, Gianni, 42555 Velbert (DE)
(74) Vertreter: Gesthuysen Patent- und Rechtsanwälte

(56) Entgegenhaltungen:
- EP-A1- 1 235 190
- EP-A2- 1 164 240
- EP-A2- 1 187 075
- DE-A1- 10 159 336

## Beschreibung

Die Erfindung betrifft einen kapazitiver Näherungsschalter, zur Erfassung einer Kapazitätsänderung ΔC relativ zu einer Sollkapazität C_{Soll} durch die Annäherung oder Entfernung eines Objekts im sensitiven Bereich des Näherungsschalters, insbesondere zur Verwendung bei einem Türgriff eines Kraftfahrzeuges, mit einem mindestens eine Ansprechelektrode aufweisenden Elektrodensystem und mit einem Schaltausgang, wobei ein der Kapazitätsänderung ΔC entsprechender Meßwert mit einer Schaltschwelle S₁ verglichen wird und wobei am Schaltausgang in Abhängigkeit vom Meßwert ein Schaltsignal erzeugt wird.

Kapazitive Näherungsschalter sprechen bekanntermaßen dann an, wenn die Kapazität zwischen der Ansprechelektrode und einer Bezugselektrode einen bestimmten Wert erreicht bzw. überschreitet, nämlich dadurch, daß sich der Ansprechelektrode ein Objekt nähert, das seinerseits mit der Bezugselektrode - galvanisch oder kapazitiv - in Verbindung steht. Als Bezugselektrode wirkt häufig das Masse- bzw. Grundpotential. Dabei wird von dem kapazitiven Näherungsschalter eine Kapazitätsänderung ΔC relativ zu einer Sollkapazität C_{Soll} erfaßt und ein entsprechender Meßwert erzeugt. Da in der Regel nicht jede noch so kleine Kapazitätsänderung ΔC zu einem Ausgangssignal führen sollen, wird der Meßwert mit einer Schaltschwelle S₁ verglichen, so daß nur dann ein Ausgangssignal, d. h. ein Schaltsignal erzeugt wird, wenn die Kapazitätsänderung ΔC bzw. der entsprechende Meßwert größer als die Schaltschwelle S₁ ist.

Bei dem Meßwert kann es sich beispielsweise um eine Spannung handeln. Als Meßwert können jedoch auch andere Größen herangezogen werden, die als Maß für eine Kapazitätsänderung ΔC dienen. Beispielsweise kann als Meßwert eine Anzahl n von getakteten Entladevorgängen eines Referenzkondensators oder eine Entladezeitdauer t_{E} herangezogen werden. Als Schaltschwelle wird dann eine Größe gewählt, die der Größe, die den Meßwert bildet, entspricht; d. h. eine Spannung, eine Anzahl n oder eine Entladezeitdauer t_{E}. Häufig soll mit dem kapazitiven Näherungsschalter die Anwesenheit eines bestimmten Objekts detektiert werden. Dabei kann dann das Problem auftreten, daß eine Kapazitätsänderung ΔC gemessen wird, die zwar größer als die Schaltschwelle S₁ ist, jedoch nicht von dem eigentlich überwachten Objekt - Sollobjekt - sondern von einem anderen Objekt - Fehlerobjekt - stammt.

Diesem Problem kann - jedenfalls theoretisch - dadurch begegnet werden, daß die Schaltschwelle S₁ so hoch gesetzt wird, daß die Wahrscheinlichkeit sehr gering ist, daß eine von einem Fehlerobjekt hervorgerufene Kapazitätsänderung ΔC bzw. der entsprechende Meßwert größer als die Schaltschwelle S₁ ist. Durch diese Maßnahme kann zwar der Großteil der möglichen Fehler unterdrückt werden, durch die Wahl einer hohen Schaltschwelle S₁ wird jedoch gleichzeitig die Empfindlichkeit des kapazitiven Näherungsschalters deutlich verringert.

Obwohl die vorliegende Erfindung ganz allgemein bei jedem kapazitiven Näherungsschalter Anwendung finden kann, bei dem sowohl eine hohe Empfindlichkeit als auch eine gute Störunterdrückung gewünscht ist, wird die Erfindung nachfolgend - ohne daß sie hierauf beschränkt sein soll - an einem konkreten Anwendungsbeispiel beschrieben, nämlich anhand eines kapazitiven Näherungsschalters, der bei einem Türgriff eines Kraftfahrzeuges eingesetzt ist und dort zur Entriegelung bzw. Verriegelung des Türschlosses dient.

Der Vorteil der Verwendung eines kapazitiven Näherungsschalters zum Entriegeln (oder auch zum Verriegeln) des Türgriffs eines Kraftfahrzeugs besteht darin, daß zwar eine gewollte Betätigung erforderlich, es genügt jedoch, wenn die Person sich einem sensitiven Bereich des Kraftfahrzeugs gezielt nähert. Als sensitiver Bereich bietet sich natürlich der Türgriff eines Kraftfahrzeugs an. (Wenn es um das Entriegeln bzw. Verriegeln des Kofferraumes eines Kraftfahrzeugs geht, kann als sensitiver Bereich für die gezielte Betätigung auch ein Betätigungsgriff am Kofferraumdeckel herangezogen werden. Im folgenden wird immer der Ausdruck Türgriff verwendet. Alles das, was in Verbindung mit dem Ausdruck Türgriff beschrieben wird, gilt selbstverständlich auch in bezug auf den Betätigungsgriff am Kofferraumdeckel.)

Seit der Frühzeit des Kraftfahrzeugs bis in die 70er Jahre hatte ein Kraftfahrzeugbesitzer kaum eine andere Möglichkeit, als sein Kraftfahrzeug mit einem mechanischen Schlüssel zu entriegeln und zu verriegeln bzw. zu entsichern und zu sichern sowie zu öffnen. Durch den zunehmenden Einsatz von Elektronik im Kraftfahrzeug haben in den 80er Jahren verstärkt zunächst Zentralver- und -entriegelungen und danach Fernbedienungen Einzug in Kraftfahrzeugen erhalten. Dabei dominieren in Nordamerika Funk-Fernbedienungen und in Europa Infrarot-Fernbedienungen. Seit einigen Jahren ist ein sogenanntes Smart-Card-System bekannt (vgl. die Literaturstelle "Siemens-Zeitschrift", 1/96, Seiten 32 - 35), bei dem im Kraftfahrzeug ein Identifikationsnehmer angeordnet ist. Um Zugang zum Kraftfahrzeug zu erlangen, d. h. um insbesondere das Türschloß zu entriegeln oder zu verriegeln, muß die Person einen Identifikationsgeber bei sich tragen. Da der Identifikationsgeber die Form und Größe einer Kreditkarte hat, ist das Mitführen dieser Karte für die Person sehr komfortabel. Durch eine von dem Identifikationsnehmer ausgehende Berechtigungsanfrage an den Identifikationsgeber kann sich dabei die Person, die den Identifikationsgeber bei sich trägt, als "berechtigte" Person ausweisen.

Ist nun die Ansprechelektrode des kapazitiven Näherungsschalters am Türgriff vorgesehen oder in den Türgriff integriert, wie es beispielsweise aus der DE 196 17 038 A1 bekannt ist, dann kann es vorkommen, daß äußere Einflüsse dazu führen, daß der kapazitive Näherungsschalter ungewollt anspricht, - beispielsweise dadurch, daß Regen, Schnee oder Eis die Kapazität zwischen der Ansprechelektrode und der Bezugselektrode hinreichend groß werden läßt. Aus der DE 196 20 059 A1 ist ein kapazitive Näherungsschalter bekannt, der so ausgeführt ist, daß er nur dann schaltet, wenn sich die Kapazität zweischen der Ansprechelektrode und der Bezugselektrode mit einer Geschwindigkeit ändert, die größer als ein unterer Grenzwert ist. Ändert sich die Kapazität zwischen der Ansprechelektrode und der Bezugselektrode mit einer Geschwindigkeit, die kleiner als ein unterer Grenzwert ist, so schaltet der Näherungsschalter nicht, auch dann nicht, wenn die Kapazität zwischen der Ansprechelektrode und der Bezugselektrode einen relativ großen Wert erreicht.

Bei einem aus der EP 1 187 075 A2 bekannten kapazitiven Näherungsschalter soll eine Unterscheidung zwischen einer Kapazitätsänderung, die durch die Annäherung einer Hand verursacht wird, und einer Kapazitätsänderung, die durch einen Regentropfen oder eine Außentemperaturänderung verursacht wird, dadurch erreicht werden, daß der Änderungsgrad und die Frequenz der jeweiligen Kapazitätsänderung berechnet wird. Nur wenn der Änderungsgrad und die Frequenz des der Kapazitätsänderung entsprechenden Meßwerts innerhalb einer vorgegebenen Bandbreite liegen, führt die Kapazitätsänderung zu einem Schaltsignal.

Bei der aus der DE 196 20 059 A1 bekannten Schaltungsanordnung zum Entriegeln mindestens eines Türschlosses eines Kraftfahrzeugs mit einem dynamisch arbeitenden kapazitiven Näherungsschalter können durch die zuvor beschriebene Auswertung der Geschwindigkeit der Kapazitätsänderung Störeinflüsse unterdrückt werden, die zu einer im wesentlichen statischen Kapazitätsänderung führen.

Daneben können jedoch auch dynamische Störeinflüsse auftreten, die dann auch zu einer dynamischen Kapazitätsänderung führen, so daß sie bei der bekannten Schaltungsanordnung bzw. bei dem bekannten kapazitiven Näherungsschalter nur dann nicht zu einem Schaltsignal führen, wenn die Schaltschwelle des kapazitiven Näherungsschalters entsprechend hoch ist.

DE 101 59 336 A1 und EP 1 235 190 A1 enthüllen ähnliche kapazitive Näherungsschalter.

Insbesondere bei der hier beispielhaft beschriebenen Anwendung eines kapazitiven Näherungsschalters zur Entriegelung eines Türschlosses eines Kraftfahrzeuges bestehen jedoch hinsichtlich der Schnelligkeit des kapazitiven Näherungsschalters relativ hohen Anforderungen. Durch die Annäherung der Hand einer Person an den Türgriff soll die Entriegelung des Türschlosses bewirkt werden, wobei zum Öffnen der Tür nach wie vor der Türgriff betätigt werden muß. Daraus ergibt sich die Anforderung, daß das Türschloß bereits entriegelt sein muß, bevor der Benutzer den Türgriff betätigt. Da darüber hinaus das Türschloß eines Kraftfahrzeuges nicht von jeder Person, die sich mit ihrer Hand dem Türgriff nähert, entriegelt werden soll, wird vor dem Entriegeln des Türschlosses in der Regel noch die Zugangsberechtigung des Benutzers überprüft. Dies kann beispielsweise mittels des zuvor beschriebenen Smart-Cart-Systems erfolgen. Aus den zuvor beschriebenen Anforderungen ergibt sich die Notwendigkeit einer Vorlaufzeit, die bei normalen Türschlössern in der Größenordnung von 100 ms liegt.

Damit innerhalb dieser Vorlaufzeit sowohl die Zugangsberechtigung des Benutzers überprüft als auch das Türschloß entriegelt werden kann, ist entweder eine sehr schnelle Datenübertragung der Berechtigungsabfrage und eine sehr schnelle Umsteuerung des Türschlosses zwischen dem Verriegelungszustand und dem Entriegelungszustand oder eine sehr hohe Empfindlichkeit des kapazitiven Näherungsschalters notwendig. Zur Erreichung einer hohen Übertragungsgeschwindigkeit der Datenkommunikation und einer schnellen Umsteuerung des Türschlosses ist sowohl ein hochwertiges - und damit teures - Übertragungssystem als auch ein hochwertiges Türschloß erforderlich.

Wenn auf der anderen Seite die benötigte Vorlaufzeit relativ groß ist, da beispielsweise der Entriegelungsmechanismus des Türschlosses relativ träge ist, muß der kapazitive Näherungsschalter auf eine sehr hohe Empfindlichkeit eingestellt werden, damit die benötigte Vorlaufzeit eingehalten werden kann. Dies führt jedoch dazu, daß auch Kapazitätsänderungen vom Näherungsschalter registriert werden, die durch Fehlerobjekte hervorgerufen werden. Bei derartigen Fehlerobjekten, die eine ungewünschte dynamische Kapazitätsänderung bewirken, kann es sich insbesondere um Regentropfen handeln.

Bei dem hier beschriebenen Anwendungsfall des kapazitiven Näherungsschalters zum Ent- bzw. Verriegeln des Türschlosses eines Kraftfahrzeuges kann dies zu nicht tolerierbaren Folgen führen. Beim Einsatz des kapazitiven Näherungsschalters im Schließsystem eines Kraftfahrzeugs ist mit dem Schaltvorgang, d. h. mit dem Anliegen eines entsprechenden Schaltsignals, des Näherungsschalters die Auslösung der Berechtigungsanfrage durch den Identifikationsnehmer verbunden. Die Aktivierung des Identifikationsnehmers verursacht eine erhöhte Stromaufnahme, die die Batterie des Kraftfahrzeuges belastet. Wenn nun bei einem länger andauernden Regen der kapazitive Näherungsschalter relativ häufig eine Kapazitätsänderung feststellt, die jedesmal zu einem Schaltsignal führt, so kann die daraus folgende häufige Berechtigungsabfrage des Identifikationsnehmers zu einer unzulässigen Entladung der Kraftfahrzeugbatterie führen.

Daraus ergibt sich für die vorliegende Erfindung die Aufgabe, einen kapaziti-Näherungsschalter mit einer zuverlässigen Fehlererkennung bzw. FehlerUnterdrückung anzugeben, wobei die Fehlerunterdrückung nicht zu einer generellen Verringerung der Empfindlichkeit des kapazitiven Näherungsschalters führen soll. Bei dem konkreten Anwendungsfall besteht die Aufgabe insbesondere darin, eine zuverlässige Regenerkennung bzw. Regenunterdrükkung zu gewährleisten, und dabei durch eine hohe Empfindlichkeit des kapazitiven Näherungsschalters eine ausreichende Vorlaufzeit zur Verfügung zu stellen.

Diese Aufgabe ist erfindungsgemäß gelöst durch einen kapazitiven Näherungsschalter mit den Merkmalen des Patentanspruchs 1.

Ein wesentlicher Aspekt des erfindungsgemäßen kapazitiven Näherungsschalters ist dabei die Verwendung einer zweiten Schaltschwelle für die Aktivierung des Schaltausgangs, d. h. für die Erzeugung des entsprechenden Schaltsignals. Für das beschriebene Anwendungsbeispiel bedeutet dies, daß dann, wenn von dem kapazitiven Näherungsschalter bzw. von der Auswerteeinheit Regen erkannt wird, die zweite Schaltschwelle S₂ aktiviert wird, so daß dann nicht mehr jede von dem kapazitiven Näherungsschalter gemessene kleine Kapazitätsänderung ΔC₁, die durch die Regentropfen hervorgerufen wird, zu einer Aktivierung des Schaltausgangs und damit zu einer - mit einer erhöhten Stromaufnahme verbundenen - Berechtigungsabfrage durch den Identifikationsnehmer führt. Erst dann, wenn die Kapazitätsänderung ΔC so groß ist, daß der Meßwert die zweite Schaltschwelle S₂ erreicht hat, liegt am Schaltausgang des kapazitiven Näherungsschalters das entsprechende Schaltsignal an. Dadurch wird eine häufige - ungewollte - Aktivierung des Identifikationsnehmers - und damit eine Entladung der Kraftfahrzeugbatterie - bei Regen verhindert. Der erfindungsgemäße kapazitive Näherungsschalter weist somit eine gute Störunterdrückung auf.

Gleichzeitig hat der kapazitive Näherungsschalter jedoch auch eine hohe Empfindlichkeit, da im Normalzustand, d. h. im regenfreien Zustand, die erste Schaltschwelle S₁ aktiviert ist, und somit die Annäherung einer Hand an den Türgriff aufgrund der hohen Empfindlichkeit bereits relativ früh erkannt wird und zu einem Schaltsignal führt. Dadurch wird eine ausreichend große Vorlaufzeit gewährleistet, innerhalb der sowohl eine Berechtigungsanfrage als auch die Entriegelung des Türschlosses sicher erfolgen kann. Lediglich wenn von dem kapazitiven Näherungsschalter ein Fehlerobjekt, im vorliegenden Fall Regen, erkannt worden ist, führt die Aktivierung der zweiten Schaltschwelle S₂ dazu, daß eine sich dem Türgriff annähernder Hand erst etwas später zu einem Schaltsignal führt, wodurch sich die Vorlaufzeit verringert. Die sich dadurch ergebende verzögerte Entriegelung des Türschlosses ist eine geringe Einbuße im Bedienkomfort, die jedoch nur Fallweise auftritt, so daß dieser kleine Nachteil in Kauf genommen werden kann.

Wie zuvor ausgeführt worden ist, erfolgt eine Aktivierung der zweiten Schaltschwelle S₂ dann, wenn von der Auswerteeinheit des kapazitiven Näherungsschalters ein Fehlerobjekt, im vorliegenden Fall Regentropfen, erkannt wird. Der erste Schritt zu einer erfolgreichen Störunterdrückung ist somit eine zuverlässige Störer- bzw. Fehlererkennung.

Erfindungsgemäß erfolgt diese Störer- bzw. Fehlererkennung dadurch, daß in der Auswerteeinheit eine zeitliche Auswertung des der Kapazitätsänderung ΔC entsprechenden Meßwertes erfolgt. Hierbei ist zunächst erkannt worden, daß zwischen dem zeitlichen Verlauf der Kapazitätsänderung ΔC, die von einem Sollobjekt - der sich annähernden oder entfernenden Hand des Benutzers - erzeugt wird und den zeitlichen Verlauf der Kapazitätsänderung ΔC, die von einem Fehlerobjekt - einen durch den sensitiven Bereich des Näherungsschalters fallenden Regentropfen - hervorgerufen wird, Unterschiede bestehen. Diese Unterschiede können durch die zeitliche Auswertung der Kapazitätsänderung ΔC erkannt und ausgewertet und dann entsprechend entweder die erste Schaltschwelle S₁ oder die zweite Schaltschwelle S, zur Erzeugung eines Schaltsignals aktiviert werden.

Bezüglich der zeitlichen Auswertung des der Kapazitätsänderung ΔC entsprechenden Meßwertes gibt es verschiedene Möglichkeiten. Wird von dem kapazitiven Näherungsschalter eine Kapazitätsänderung ΔC registriert, die einen Meßwertes erzeugt, der größer als die erste Schaltschwelle S₁ ist, so kann zunächst der zeitliche Verlauf der Kapazitätsänderung ΔC bzw. des Meßwertes noch für eine bestimmte Zeitdauer weiter überwacht bzw. gespeichert werden. Innerhalb dieser Zeitdauer ist dann aufgrund des zeitlichen Verlaufs der Kapazitätsänderung ΔC eine Aussage möglich, ob die Kapazitätsänderung ΔC durch das Sollobjekt oder durch ein Fehlerobjekt hervorgerufen worden ist.

Ein mögliches Kriterium zur Unterscheidung zwischen dem Sollobjekt und einem Fehlerobjekt kann dabei beispielsweise das Auftreten eines oder mehrerer lokaler Maxima bzw. Minima im zeitlichen Verlauf des Meßwertes sein. Beim Annähern einer Hand an den Türgriff eines Kraftfahrzeugs erfolgt eine kontinuierliche Erhöhung der Kapazität C, so daß auch der Signalverlauf des Meßwertes monoton verläuft. Im Unterschied dazu weist der Signalverlauf einer Kapazitätsänderung ΔC, die durch einzelne Regentropfen verursacht ist, einen oder mehrere lokale Maxima bzw. Minima auf.

Gemäß einer vorteilhaften Ausgestaltung weist der erfmdungsgemäße kapazitive Näherungsschalter einen Speicher auf, in dem mindestens ein typischer Signalverlauf der Kapazitätsänderung ΔC bzw. des Meßwertes abgelegt ist, so daß die zeitliche Auswertung des Meßwertes anhand eines Vergleichs des zeitlichen Verlaufs des Meßwertes mit dem gespeicherten Signalverlauf erfolgt. Bei der Verwendung eines entsprechend "intelligenten" kapazitiven Näherungsschalters ist dabei eine Mustererkennung möglich, so daß auch unterschiedliche Fehlerobjekte erkannt und zwischen diesen Fehlerobj ekten unterschieden werden kann.

Gemäß einer besonders bevorzugten Ausgestaltung des kapazitiven Näherungsschalters, bei dem auf besonders einfache Art und Weise eine zuverlässige Störer- bzw. Fehlererkennung realisiert ist, weist die Auswerteeinheit einen Zähler auf, wobei von dem Zähler die Anzahl N der Kapazitätsänderungen ΔC₁ pro Zeitdauer T₁ erfaßt wird und wobei die zweite, höhere Schaltschwelle S₂ dann aktiviert wird, wenn die Anzahl N einen Grenzwert G₁ übersteigt.

Bei dieser besonders vorteilhaften Ausgestaltung des kapazitiven Näherungsschalters ist zunächst erkannt worden, daß Fehlerobjekte häufig intervallweise und mit einer gewissen Regelmäßigkeit auftreten. Bezüglich des beschriebenen Anwendungsbeispiels bedeutet dies, daß bei Regen pro Zeitdauer eine bestimmte Anzahl an Regentropfen durch den sensitiven Bereich des Näherungsschalters fallen. Einige dieser Regentropfen können dabei so groß sein, daß sie eine Kapazitätsänderung ΔC₁ hervorrufen, die einen Meßwert erzeugt, der größer als die erste Schaltschwelle S₁ ist. Diese Regentropfen würden somit - ohne die erfindungsgemäße Fehlererkennung - am Schaltausgang des kapazitiven Näherungsschalters ein Schaltsignal erzeugen. Dadurch, daß die Auswerteeinheit einen Zähler aufweist, der die Anzahl N der Kapazitätsänderungen ΔC₁ pro Zeitdauer T₁ erfaßt, ist durch einen Vergleich der so ermittelten Zählrate N mit einem geeignet gewählten Grenzwert G₁ eine Regenerkennung möglich. Übersteigt die Anzahl N den Grenzwert G₁ so wird dies von der Auswerteeinheit als Regen interpretiert. Dies führt dann - wie eingangs bereits beschrieben - dazu, daß die zweite, höhere Schaltschwelle S₂ aktiviert wird wodurch verhindert wird, daß durch die einzelnen Regentropfen am Schaltausgang ständig ein Schaltsignal erzeugt wird. Erst wenn die Kapazitätsänderung ΔC einen Meßwert erzeugt, der die Schaltschwelle S₂ übersteigt, wird dies von der Auswerteeinheit als Annäherung einer Hand interpretiert und am Schaltausgang das entsprechende Schaltsignal erzeugt.

Erfindungsgemäß wird dabei auch dann, wenn das Schaltsignal am Schaltausgang durch die Schaltschwelle S₂ bestimmt wird, der Meßwert stets auch mit der ersten Schaltschwelle S₁ verglichen. Hierdurch ist gewährleistet, daß auch bei aktivierter zweiter Schaltschwelle S₂ dauernd überprüft wird, ob die zuvor detektierten Fehlerobjekte nach wie vor vorhanden sind; ob es immer noch regnet. Da während der Aktivierung der zweiten Schaltschwelle S₂ die Empfindlichkeit des kapazitiven Näherungsschalters verringert ist, ist es wünschenswert, bei Regenende möglichst schnell wieder zur ersten Schaltschwelle S₁ zurückkehren, um die gewünschte hohe Empfindlichkeit des Näherungsschalters ausnutzen zu können. Daher wird vorteilhafterweise bei aktivierter zweiten Schaltschwelle S₂ dann wieder die erste Schaltschwelle S₁ aktiviert, wenn die Anzahl N der Kapazitätsänderungen ΔC₁ pro Zeitdauer T₂ unter einen Grenzwert G₂ fällt.

Da bei der bevorzugten Ausführung des kapazitiven Näherungsschalters eine Kapazitätsänderung ΔC gleichzeitig mit mindestens zwei Schaltschwellen S₁, S₂ verglichen wird, wird bei dem beschriebenen Ausfübrungsbeispiel sowohl der Regenanfang als auch das Regenende detektiert. Dabei ist für die Störer- bzw. Fehlererkennung immer die erste, niedrigere Schaltschwelle S₁ aktiv, während für den Schaltausgang gegebenenfalls die zweite, höhere Schaltschwelle S₂ aktiviert ist. Die eigentliche Empfindlichkeit des kapazitiven Näherungsschalters wird somit nicht verändert; sie ist durch die Schaltschwelle S₁ bestimmt.

Vorteilhafter ist die Umschaltung zwischen den verschiedenen Schaltschwellen mit einer Hysterese versehen. Dies kann auf einfache Art und Weise durch eine entsprechende Wahl der Grenzwerte G₁, G₂ realisiert werden, wobei der Grenzwert G₁ deutlich höher als der Grenzwert G₂ gewählt werden sollte. Bei der Wahl eines Grenzwertes G₁, der mindestens zweimal, vorzugsweise vier bis fünfmal so groß ist wie der Grenzwert G₂ wird erreicht, daß nach einer Regenerkennung nicht vorschnell wieder auf die erste Schaltschwelle S₁ umgeschaltet wird, da es ansonsten zu einem zu häufigen Aktivieren des Schaltausgangs, verursacht durch eine nach wie vor vorhandene, wenn auch geringere Anzahl an Regentropfen, kommen könnte.

Durch die Wahl der Grenzwerte G₁, G₂ ist dabei nicht nur die Einstellung einer Hysterese möglich, sondern darüber hinaus auch eine Anpassung des kapazitiven Näherungsschalters an den jeweiligen Anwendungsfall. Eine derartige optimierte Anpassung an dem jeweiligen Anwendungsfall wird vorzugsweise auch dadurch erreicht, daß die Zeitdauer T₁, während der vom Zähler die Anzahl N der Kapazitätsänderungen ΔC₁ erfaßt wird, geringer ist als die Zeitdauer T₂, während der vom Zähler bei aktivierter zweiter Schaltschwelle S₂ die Anzahl N der Kapazitätsänderungen ΔC₁ erfaßt wird. Dadurch wird erreicht, daß bei auftretendem Regen relativ schnell die zweite Schaltschwelle S₂ aktiviert wird, wodurch ein zu starkes Entladen der Kraftfahrzeugbatterie verhindert wird. Wie eingangs bereits ausgeführt worden ist, ist bei der Verwendung des kapazitiven Näherungsschalters zur Entriegelung eines Türgriffs eines Kraftfahrzeugs eine durch einzelne Regentropfen verursachte häufige Aktivierung des Identifikationsnehmers aufgrund der damit verbundenen Entladung der Kraftfahrzeugbatterie der kritischere Zustand, während der durch eine verzögerte Entriegelung des Türschlosses verbundene geringere Bedienkomfort relativ unkritisch ist. Daher kann durch die Wahl einer längerer Zeitdauer T₂ der Entscheidungszeitraum zur sichereren Feststellung des Regenendes verlängert werden.

Wie zuvor bereits ausgeführt worden ist, können die Grenzwerte G₁, G₂ und die Zeitdauer T₁, T₂ zur verbesserten Anpassung an den jeweiligen Anwendungsfall einstellbar sein. Eine entsprechende Einstellung ist dabei vorzugsweise auch für die Schaltschwellen S₁, S₂ vorgesehen. Die Einstellung der einzelnen Werte kann dabei entweder vom Benutzer vorgenommen werden oder sie erfolgt - jedenfalls innerhalb bestimmter Grenzen - selbstständig durch die Auswerteeinheit des kapazitiven Näherungsschalters.

Hierbei kann eine Einlernphase (Teach-In) vorgesehen sein, innerhalb der aufgrund der zeitlichen Auswertung der Kapazitätsänderung ΔC bzw. des Meßwertes von der Auswerteeinheit bzw. von einem zu der Auswerteeinheit gehörenden Mikroprozessor die Schaltschwellen, die Grenzwerte und/oder die Zeitdauer eingestellt werden. Durch eine derartige Einlernphase kann der kapazitive Näherungsschalter auf das typische Benutzerverhalten der berechtigten Person trainiert werden. Auf diese Weise ist es möglich, unberechtigten Personen, die im Besitz des Identifikationsgebers sind, den Zugang zum Kraftfahrzeug zu verweigern. So kann beispielsweise kleinen Kindern, die nicht die benutzertypischen Kapazitätsänderungen hervorrufen, der Zugang zum Kraftfahrzeug versperrt werden, auch wenn die Kinder durch Zufall oder Unachtsamkeit der Eltern in den Besitz des Identifikationsgebers gelangt sind.

Gemäß einer weiteren vorteilhaften Ausgestaltung des erfindungsgemäßen kapazitiven Näherungsschalters, die hier noch kurz erwähnt werden soll, wird die Sollkapazität C_{Soll} dynamisch der gemessenen Istkapazität C_{Ist} nachgeführt, so daß eine - an sich bekannte - Driftkorrektur realisiert ist. Die Driftkorrektur ist dabei relativ langsam im Vergleich zu der durch das Sollobjekt oder die Fehlerobjekte auftretenden Kapazitätsänderung ΔC. Die Änderung der Istkapazität C_{Ist}, die durch die Driftkorrektur berücksichtigt wird, beruht beispielsweise auf Temperaturänderungen oder Ablagerungen auf dem Türgriff, durch die die Istkapazität C_{Ist} beeinflußt wird. Meßtechnisch wird dabei nicht direkt die Sollkapazität C_{Soll} verändert, sondern es werden die Schaltschwellen nachgeführt, was dazu führt, daß auch bei einer beispielsweise durch eine Temperaturänderung hervorgerufenen Änderung der Istkapazität C_{Ist} weiterhin dieselbe Kapazitätsänderung ΔC erforderlich ist, um ein Schaltsignal zu erzeugen.

Neben der relativ langsamen dynamischen Nachführung der Sollkapazität C_{Soll} bzw. der Schaltschwellen kann darüber hinaus auch die Geschwindigkeit der Kapazitätsänderung ΔC/Δt erfaßt werden und mit einer oder mehreren in einem Speicher abgelegten Grenzgeschwindigkeiten v₁, v₂ verglichen werden, wobei bei einer Kapazitätsänderung ΔC, die einen Meßwert erzeugt, der größer als die aktivierte Schaltschwelle S₁, S₂ ist, nur dann eine Aktivierung des Schaltausgangs erfolgt, wenn die Geschwindigkeit der gemessenen Kapazitätsänderung ΔC/Δt größer als eine untere Grenzgeschwindigkeit v₁ und/oder kleiner als eine obere Grenzgeschwindigkeit v₂ ist. Hierdurch kann die Gefahr einer ungewollten Aktivierung des Schaltausgangs des kapazitiven Näherungsschalters weiter minimiert werden. Die untere und obere Grenzgeschwindigkeit v₁, v₂ kann beispielsweise durch die Wahl einer Mindest- und Maximalgeschwindigkeit für eine typische Handbewegung eingestellt werden. Die untere und obere Grenzgeschwindigkeit v₁, v₂ kann indirekt auch dadurch eingestellt werden, daß mehrere Schaltschwellen definiert sind, die unterschiedlich schnell dem gemessenen Meßwert nachgeregelt sind. Eine schnelle Regelung führt dazu, daß nur bei mit einer entsprechend schnellen Kapazitätsänderungen ΔC die Schaltschwelle erreicht wird.

Die Auswertung der Kapazitätsänderungs-Geschwindigkeit ΔC/Δt zusätzlich zur Auswertung der Kapazitätsänderung ΔC ermöglicht darüber hinaus das Festlegen von bestimmten Bedienvorschriften, beispielsweise für sicherheitsrelevante Anwendungen. Dies bedeutet, daß ein bestimmter Schaltvorgang nur bewußt und nicht zufällig oder unbedacht ausgelöst werden kann. Im Extremfall kann dies durch die Erfüllung eines bestimmten Codes erreicht werden, der beispielsweise eine Folge verschieden schneller Annäherungen einer Hand an den Türgriff als Zugangsberechtigung erkennt. Bei einem derartig ausgebildeten kapazitiven Näherungsschalter wäre dann die Verwendung eines Smart-Card-Systems nicht zwingend erforderlich.

Eine andere Anwendung der Auswertung der Geschwindigkeit der Kapazitätsänderung ΔC/Δt ist die Realisierung einer Vorlaufzeitstabilisierung. Schnelle Handbewegungen eines Benutzers führen bei gleicher Empfindlichkeit des kapazitiven Näherungsschalters zu kürzeren Vorlaufzeiten als langsame Handbewegungen, da die Detektierung von der Entfernung der Hand von der Ansprechelektrode abhängt. Durch eine entsprechende Regelung der Empfindlichkeit des kapazitiven Näherungsschalters, d. h. der ersten Schaltschwelle S₁ in Abhängigkeit von einer eingestellten oder gemessenen Geschwindigkeit der Kapazitätsänderung ΔC/Δt kann die erforderliche Vorlaufzeit eingestellt werden. Bei einem Benutzer, der seine Hand relativ schnell an den Türgriff annähert muß somit eine geringere Schaltschwelle S₁ gewählt werden, als bei einem Benutzer, der mit seiner Hand relativ langsam zum Türgriff greift.

Bei einigen Anwendungsfällen kann es darüber hinaus sinnvoll oder vorteilhaft sein, mehr als zwei Schaltschwellen vorzusehen. Durch die Erhöhung der Anzahl der Schaltschwellen kann die Auflösung der detektierten Kapazitätsänderung ΔC erhöht werden. Durch eine erhöhte Auflösung ist es beispielsweise möglich, verschiedene Sollobjekte zu erkennen und ggf. zuzuordnen.

Auch wenn der erfindungsgemäße kapazitive Näherungsschalter für verschiedene Anwendungsfälle geeignet ist, so ist er besonders vorteilhaft bei einem Türgriff eines Kraftfahrzeuges zur Ent- bzw. Verriegelung des Türschlosses einsetzbar. Daher betrifft die vorliegende Erfindung auch eine Schaltungsanordnung zum Entriegeln mindestens eines Türschlosses eines Kraftfahrzeugs, mit einer elektronischen Aktivierungsschaltung und mit einem erfindungsgemäßen kapazitiven Näherungsschalter, wobei die Ansprechelektrode des kapazitiven Näherungsschalters in dem Türgriff integriert ist. Die Schaltungsanordnung ist dabei dadurch gekennzeichnet, daß die Entriegelung oder die Verriegelung des Türschlosses nur dann erfolgt, wenn von einer in den sensitiven Bereich des Näherungsschalters ein- oder austretenden Hand einer Person eine Kapazitätsänderung ΔC hervorgerufen wird, die einen Meßwert erzeugt, der größer als die aktivierte Schaltschwelle S₁, S₂ ist, so daß am Schaltausgang des kapazitiven Näherungsschalters ein Schaltsignal anliegt und wenn ausgelöst durch das Schaltsignal des kapazitiven Näherungsschalters von der elektronischen Aktivierungsschaltung die Person als berechtigte Person erkannt worden ist.

Bei der hier beschriebenen elektronischen Aktivierungsschaltung kann es sich dabei insbesondere um das eingangs beschriebene Smart-Card-System handeln. Vorzugsweise werden bei dem zuvor beschriebenen Schaltungssystem den Schaltschwellen S₁, S₂ und/oder den Grenzwerten G₁, G₂ und/oder der Zeitdauer T₁, T₂ und/oder den Grenzgeschwindigkeiten v₁, v₂ unterschiedliche Werte in Abhängigkeit davon zugewiesen, ob das Türschloß entriegelt oder verriegelt ist. Hierbei wird der Tatsache Rechnung getragen, daß nur beim Entriegeln des Türschlosses die Vorlaufzeit kritisch ist, da beim Verriegeln des Türschlosses in der Regel keine Betätigung des Türgriffs erfolgt.

Gemäß einer letzten vorteilhaften Ausgestaltung der Schaltungsanordnung ist ein zweiter Sensor, insbesondere ein zweiter kapazitiver Näherungsschalter vorgesehen, der als Regensensor fungiert und vorzugsweise darüber hinaus auch das Schaltsignal zum Verriegeln des Türschlosses liefert, während der erste kapazitive Näherungsschalter nur das Schaltsignal zum Entriegeln des Türschlosses liefert. Wie zuvor bereits ausgeführt, ist die Vorlaufzeit beim Verriegeln des Türschlosses unkritisch, so daß hierfür auch nur geringere Anforderungen an den Sensor gestellt werden müssen. Insbesondere kann somit die Zeitdauer T für den zweiten Sensor deutlich länger gewählt werden, wodurch gleichzeitig eine sicherere Aussage über das Vorliegen von Regen erfolgen kann.

Im einzelnen gibt es nun eine Vielzahl von Möglichkeiten den erfindungsgemäßen kapazitiven Näherungsschalter auszugestalten und weiterzubilden. Hierzu wird verwiesen sowohl auf die dem Patentanspruch 1 bzw. dem Patentanspruch 15 nachgeordneten Patentansprüche als auch auf die nachfolgende Beschreibung von Ausführungsbeispielen in Verbindung mit der Zeichnung. In der Zeichnung zeigen
- Fig. 1: schematisch, ein Kraftfahrzeug mit einer erfindungsgemäßen Schaltungsordnung, in Draufsicht,
- Fig. 2: den Türgriff eines Kraftfahrzeugs von innen, also von der Tür aus gesehen,
- Fig. 3: ein Blockschaltbild der erfindungsgemäßen Schaltungsanordnung,
- Fig. 4: ein Zeitdiagramm zur Darstellung der Kapazitätsänderung ΔC bei unterschiedlichen Objekten,
- Fig. 5: ein vereinfachtes Schaltbild einer bevorzugten Ausführung des erfindungsgemäßen kapazitiven Näherungsschalters,
- Fig. 6: ein Zeitdiagramm zur Darstellung der Messung eine Kapazitätsänderung ΔC bei dem kapazitiven Näherungsschalters gemäß Fig. 4,
- Fig. 7: ein Zeitdiagramm zur Darstellung der Meßwerte bei einem Fehlerobjekt und bei Annäherung einer Hand,
- Fig. 8: ein Zeitdiagramm der Kapazitätsänderung ΔC zur Darstellung der Abhängigkeit der Vorlaufzeit von der Schaltschwelle S,
- Fig. 9: ein Ablaufschema der Umschaltung zwischen zwei Schaltschwellen S₁, S₂ und
- Fig. 10: ein Zeitdiagramm zur Darstellung der Driftkorrektur.

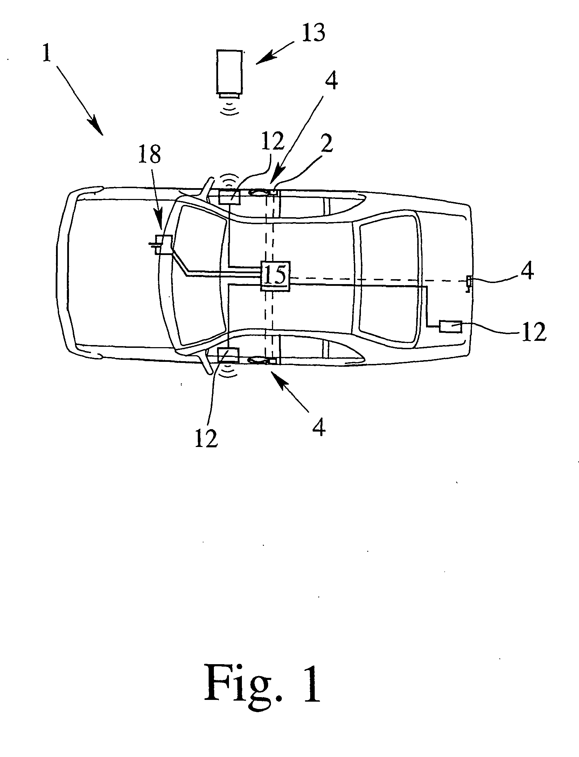

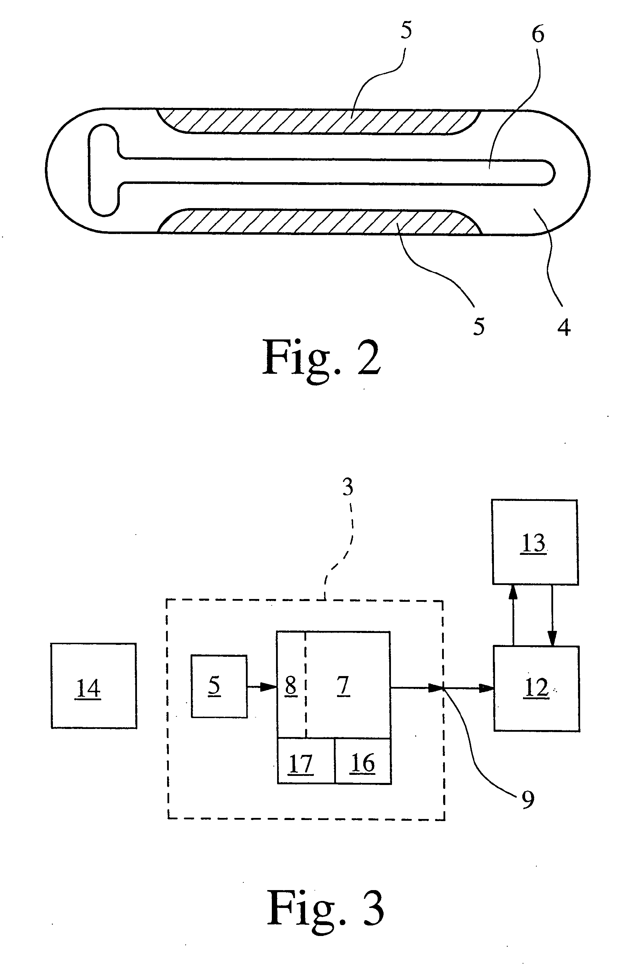

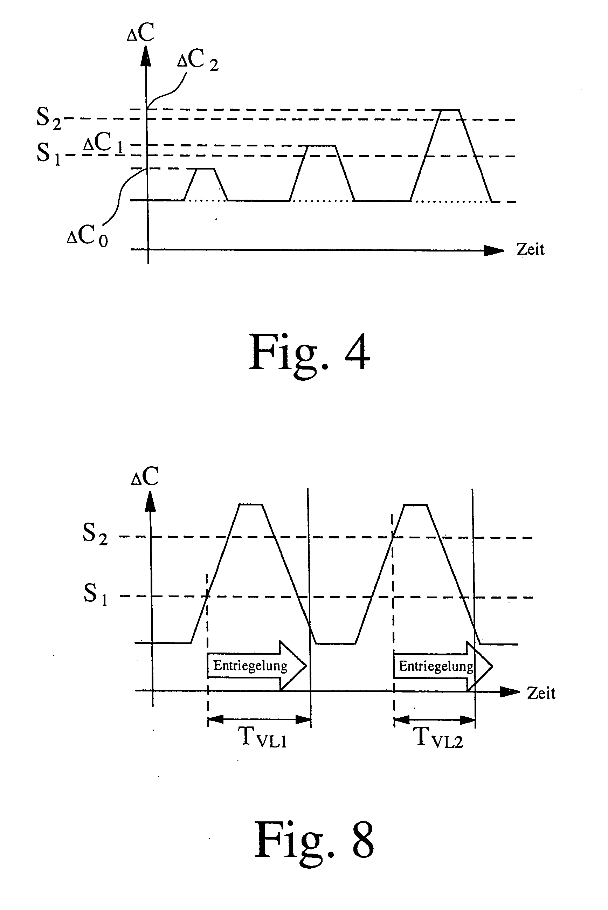

Fig. 1 zeigt schematisch ein Kraftfahrzeug 1 welches eine Schaltungsanordnung zum Ent- bzw. Verriegeln mindestens eines Türschlosses 2 mit einer elektronischen Aktivierungsschaltung und mit einem kapazitiven Näherungsschalter 3 aufweist, wobei in dem Türgriff 4 eine Ansprechelektrode 5 und eine Kompensationselektrode 6 des Näherungsschalters 3 integriert sind. Die Kompensationselektrode 6 ist dabei lediglich in Fig. 2 dargestellt, nicht jedoch in dem vereinfachten Schaltbild des Näherungsschalters 3 gemäß Fig. 4. Wie ein mögliches Schaltbild eines kapazitiven Näherungsschalters 3, der neben einer Ansprechelektrode 5 auch eine Kompensationselektrode 6 aufweist, aussehen kann, kann der Fig. 3 der DE 196 20 059 A1 entnommen werden.

Wie sich aus dem in Fig. 3 dargestellten Blockschaltbild der Schaltungsanordnung ergibt, gehören zu dem kapazitiven Näherungsschalter 3 neben dem die Ansprechelektrode 5 aufweisenden Elektrodensystem eine Auswerteeinheit 7, mit einem eine Schaltschwelle S₁ aufweisenden Komparator 8 und ein Schaltausgang 9. An einem Eingang 10 des - nur in Fig. 4 dargestellten - Komparators 8 liegt ein Spannung U_{Meß} an, während eine dem anderen Eingang 11 des Komparators 8 eine der ausgewählten Schaltschwelle entsprechende Referenzspannung U_{ref} anliegt.

Hat der von dem kapazitiven Näherungsschalter 3 gemessene Meßwert, der der Kapazitätsänderung ΔC entspricht, die Schaltschwelle erreicht, so liegt am Schaltausgang 9 ein entsprechendes Schaltsignal an. Durch das Schaltsignal wird dann der Identifikationsnehmer 12 der elektronischen Aktivierungsschaltung ausgelöst, so daß ausgehend von dem Identifikationsnehmer 12 eine Berechtigungsanfrage an den Identifikationsgeber 13 gesendet wird. Ist die Person, deren Hand 14 sich dem Türgriff 4 nähert im Besitz des richtigen Identifikationsgebers 13, so wird durch Rücksendung eines entsprechenden Erkennungssignals an den Identifikationsnehmer 12 die Person als die "berechtigte" Person identifiziert. Über eine in dem Kraftfahrzeug 1 angeordnete Steuereinheit 15 wird dann die Entriegelung des Türschlosses 2 gesteuert, wobei die Zeit (Vorlaufzeit) zwischen dem Detektieren der sich dem Türgriff 4 annähernden Hand 14 und der Betätigung des Türgriffs 4 aufgrund der hohen Empfindlichkeit des Näherungsschalters 3 ausreichend ist, daß sowohl die Berechtigungsabfrage als auch die Entriegelung des Türschlosses 2 abgeschlossen ist, bevor die Person den Türgriff 4 zum Öffnen der Tür betätigt.

Wie in Fig. 3 schematisch dargestellt ist, weist die Auswerteeinheit 7, die insgesamt als Mikrocontroller ausgebildet sein kann, noch einen Speicher 16 und einen Zähler 17 auf. In dem Zähler 17 wird dabei die Anzahl N der Kapazitätsänderungen ΔC₁ pro Zeitdauer T₁ erfaßt, die größer als die erste Schaltschwelle S₁ sind. Übersteigt die Anzahl N einen vorgegebenen Grenzwert G₁, so wird dies von der Auswerteeinheit 7 als Vorhandensein von Regen interpretiert, und es wird - zur Unterdrückung der durch den Regen ansonsten verursachten Schaltsignale am Schaltausgang 9 - durch die Auswerteeinheit 7 eine zweite Schaltschwelle S₂ aktiviert. Die zweite Schaltschwelle S₂ kann beispielsweise dadurch realisiert werden, daß ein zweiter Komparator mit einer der Schaltschwelle S₂ entsprechenden Referenzspannung an seinem zweiten Eingang vorgesehen ist, oder das bei nur einem Komparator 8 an dessen zweiten Eingang 11 abwechselnd die erste Schaltschwelle S₁ und die zweite Schaltschwelle S₂ angelegt wird. Entscheiden ist lediglich, daß die gemessene Kapazitätsänderung ΔC₁ mit beiden Schaltschwelle S₁, S2 verglichen wird.

Wie sich aus dem in Fig. 4 dargestellten Zeitdiagramm der Kapazitätsänderung ΔC relativ zu einer Sollkapazität C_{Soll} ergibt, hängt die Größe der Kapazitätsänderung ΔC von dem Objekt ab, das sich innerhalb des sensitiven Bereichs des Näherungsschalters 3 befindet. In der Fig. 4 sind mit ΔC₀, ΔC₁ und ΔC₂ drei Kapazitätsänderungen ΔC aufgetragen, die von einem sehr kleinen, einem mittleren und einem relativ großen Objekt hervorgerufen werden. Die von dem sehr kleinen Objekt hervorgerufene Kapazitätsänderung ΔC₀ ist dabei kleiner als die erste Schaltschwelle S₁, so daß dieses Objekt von dem kapazitiven Näherungsschalter 3 - bewußt - nicht registriert wird. Ein derartig kleines Objekt als Fehlerobjekt führt somit nicht zu einem Schaltsignal am Schaltausgang 9 des kapazitiven Näherungsschalters 3.

Die von dem mittleren Objekt hervorgerufene Kapazitätsänderung ΔC₁ ist größer als die untere Schaltschwelle S₁, so daß dieses Objekt, beispielsweise ein durch den sensitiven Bereich des Näherungsschalters 3 fallender Regentropfen, von dem kapazitiven Näherungsschalter 3 detektiert wird und ein Schaltsignal am Schaltausgang 9 erzeugt. Dadurch, daß nun erfindungsgemäß bei Erkennen von Regen die zweite, höhere Schaltschwelle S₂ aktiviert wird, die höher als die Kapazitätsänderung ΔC₁ ist, führt die von dem kapazitiven Näherungsschalter 3 zwar detektierte Kapazitätsänderung ΔC₁ nicht zu einem Schaltsignal am Schaltausgang 9 des Näherungsschalters 3. Erst dann, wenn ein großes Objekt - die Hand eines Benutzers - in dem sensitiven Bereich des Näherungsschalters 3 tritt, wird dadurch eine Kapazitätsänderung ΔC₂ hervorgerufen, die größer als die zweite Schaltschwelle S₂ ist. Diese Kapazitätsänderung ΔC₂ führt dann zu dem Schaltsignal am Schaltausgang 9 des Näherungsschalters 3, was bei der in Fig. 1 dargestellten Schaltungsanordnung zur Aktivierung des Identifikationsnehmers 12 und damit zu einer Berechtigungsabfrage führt.

Durch die in Abhängigkeit von der Störererkennung wahlweisen Aktivierung einer zweiten, höheren Schaltschwelle S₂ für die Aktivierung des Schaltausganges 9 wird somit verhindert, daß bei Regen der Identifikationsnehmer 12 sehr häufig aktiviert wird, was zu einer Entladung der Kraftfahrzeugbatterie 18 führen könnte.

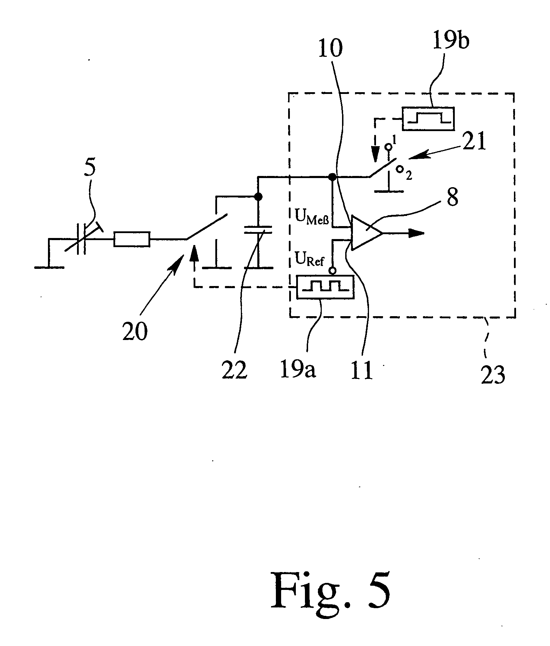

Zu dem in Fig. 5 dargestellten vereinfachten Schaltbild des kapazitiven Näherungsschalter 3 gehören zunächst die Ansprechelektrode 5, zwei Taktgenerator 19a ,19b und zwei von den Taktgeneratoren 19a, 19b gesteuerte Umschaltkontakte 20, 21. Die Frequenz f₁ des Taktgenerators 19a ist dabei deutlich größer als die Frequenz f₂ des Taktgenerators 19b. Beispielsweise ist die Frequenz f₁ = 200 kHz, während die Frequenz f₂ = 33 Hz ist. Die zu messende Kapazität Cₓ ist zwischen der Ansprechelektrode 5 und der Hand 14 des Benutzers, d. h. dem Massepotential wirksam. Die Ansprechelektrode 5 ist über einen Ankoppelwiderstand mit dem Eingang des ersten Umschaltkontaktes 20 verbunden. Zu dem dargestellten kapazitiven Näherungsschalter 3 gehören weiter ein Referenzkondensator 22, der mit seiner einen Elektrode über den ersten Umschaltkontakte 20 mit der Ansprechelektrode 4 verbindbar ist und mit seiner anderen Elektrode mit dem Bezugspotential (Massepotential) verbunden ist. Mit einer derartigen Schaltung ist eine getaktete Entladung des parallel zur zu messenden Kapazität Cₓ liegenden Referenzkondensator 22 auf eine Referenzspannung U_{ref} möglich. Die Auswerteeinheit 7, der Komparator 8, die Taktgeneratoren 19a, 19b und die Umschaltkontakte 20, 21 können dabei Teil eines Mikroprozessors 23 sein.

Nachdem der Referenzkondensator 22 auf einen festen Wert aufgeladen worden ist, wird der Umschaltkontakt 21 von der ersten Stellung in die zweite Stellung verbracht und dann die zu messende Kapazität Cₓ abwechseln über den Umschaltkontakt 20 mit dem Referenzkondensator 22 und dem Bezugspotential (Massepotential) verbunden. Ist die Ansprechelektrode 5 mit dem Referenzkondensator 22 verbunden, so wird die gesuchte Kapazität Cₓ aufgeladen, wobei die transportiert Ladung Q proportional zur Kapazität Cₓ ist. Anschließend wird die zu messende Kapazität Cₓ über den Umschaltkontakt 20 mit dem Bezugspotential verbunden und dadurch entladen, bevor ein neuer Ladevorgang beginnt. Die bekannte Ladung Q_{ref}, die sich zu Beginn der Messung in Referenzkondensator 22 befindet, wird somit Portionsweise mittels der gesuchten Kapazität Cₓ zum Bezugspotential transportiert. Die Anzahl n der zur Entladung notwendigen Takte ist ein Maß für die gesuchte Kapazität. Je größer die gesuchte Kapazität Cₓ ist, desto weniger Takte sind zur Entladung der Referenzkondensators 22 notwendig. Wird am Eingang 10 des Komparators 8 die Referenzspannung U_{ref} erreicht, so wird der Zählvorgang beendet. Der Meßwert entspricht dann der erreichten Anzahl n.

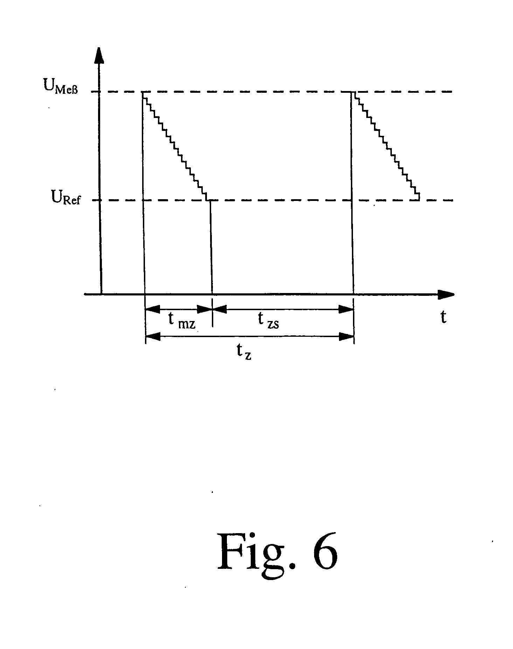

Fig. 6 zeigt ein Zeitdiagramm zur Darstellung der Messung eine Kapazitätsänderung ΔC bei dem kapazitiven Näherungsschalters 3 dessen Schaltbild in Fig. 5 dargestellt ist. Wie zuvor bereits ausgeführt, wird als Meßwert für die gesuchte Kapazitätsänderung ΔC die Anzahl n der zur Entladung notwendigen Takte, d. h. der Umladevorgänge, gezählt, die notwendig ist, bis die gemessenen Spannung U_{Meß} am Eingang 10 des Komparators 8 der Referenzspannung U_{ref} entspricht. Die Anzahl n verringert sich dabei bei Annäherung eines Objekts an die Ansprechelektrode 5. Alternativ zur Messung der Anzahl n kann auch die Zeit t gemessen werden, die vergeht, bis Referenzspannung U_{ref} erreicht ist. Der Meßwert - Anzahl n oder Zeit t - ist somit ein Integrationswert, der proportional zur gesuchten Kapazitätsänderung ΔC ist.

Aus Fig. 6 ist außerdem entnehmbar, daß die einzelnen Meßzyklen mit einer Zykluszeit t_{MZ} intermittierend erfolgen. Die Zykluszeit t_{MZ} eines Meßzyklus ist somit kürzer als die Gesamtzykluszeit t_{Z}. Um den Stromverbrauch des kapazitiven Näherungsschalters 3 zu reduzieren wird der Mikroprozessor 23 während der Zeitdauer t_{ZS} in einen Schlafmodus versetzt. Das Verhältnis von Zykluszeit t_{MZ} zu Zeitdauer t_{ZS} beträgt dabei zwischen 1 : 2 bis 1 : 8. Bei einem Gesamtzykluszeit t_{Z} = 30 ms beträgt die Zykluszeit t_{MZ} beispielsweise 10 ms.

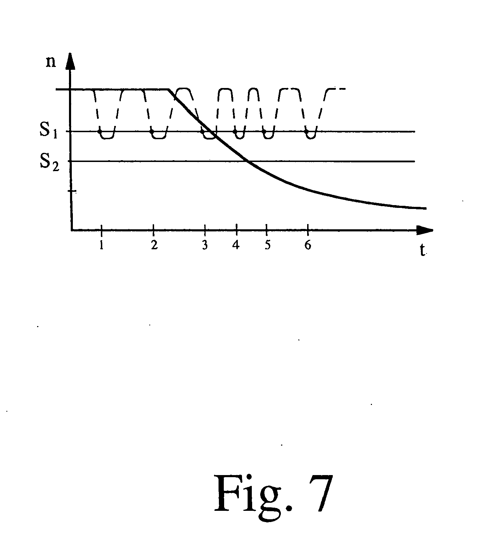

Fig. 7 zeigt ein Zeitdiagramm zur Darstellung der Meßwerte bei einem Fehlerobjekt und bei Annäherung einer Hand, wobei auch hier als Meßwert für die gesuchte Kapazitätsänderung ΔC die Anzahl n der zur Entladung notwendigen Takte gezählt wird. Im unbedämpften Zustand, d. h. wenn sich kein Objekt der Ansprechelektrode 5 hinreichend genähert hat, beträgt diese Anzahl beispielsweise n = 2500. Bei Annäherung eines Objektes vergrößert sich die Kapazität, wodurch sich die Anzahl n verringert. Die erste Schaltschwelle S₁, bei der eine Kapazitätsänderung ΔC₁ vorliegt, beträgt beispielsweise n = 2450. Die zweite Schaltschwelle S₂, die bei einer Kapazitätsänderung ΔC₂ erreicht wird, beträgt beispielsweise n = 2300. Während dabei zwar die Kapazitätsänderung ΔC₂ größer als die Kapazitätsänderung ΔC₁ ist, ist die zweite Schaltschwelle S₂ kleiner als die erste Schaltschwelle S₁. Ob die erste Schaltschwelle S₁ oder die zweite Schaltschwelle S₂ größer ist, hängt somit davon ab, welche Größe als Meßwert für eine Kapazitätsänderung ΔC herangezogen wird.

Die in Fig. 7 durchgezogene Linie zeigt den Meßwert einer sich annähernden Hand 14, während die gestrichelte Linie den Meßwert von Regen darstellt. Durch die Veilzahl der den kapazitiven Näherungsschalter 3 beeinflussenden Regentropfen wird dabei innerhalb einer bestimmten Zeitdauer T₁ eine Anzahl N von Kapazitätsänderung ΔC₁ erfaßt, während bei einer sich annähernden Hand 14 nur eine Kapazitätsänderung ΔC₁ erfaßt wird. Bei einer Anzahl N, die größer als ein unterer Grenzwert G₁ ist, wird dann von der Auswerteeinheit Regen erkannt und die zweite Schaltschwelle S₂ aktiviert.

Der Fig. 7 kann darüber hinaus auch entnommen werden, daß eine Unterscheidung zwischen einer sich annähernden Hand 14 und Regentropfen auch durch das Auftreten eines oder mehrerer lokaler Minima im zeitlichen Verlauf des Meßwertes erfolgen kann. Beim Annähern einer Hand 14 an den Türgriff 4 eines Kraftfahrzeugs 1 erfolgt eine kontinuierliche Erhöhung der Kapazität C, so daß der Signalverlauf des Meßwertes - bei Auswertung der Anzahl n - monoton fallend ist. Im Unterschied dazu weist der Verlauf des Meßwertes, der durch den Regen verursacht ist, mehrere lokale Minima auf.

Aus dem in Fig. 8 dargestellten Zeitdiagramm der Kapazitätsänderungen ΔC ist ersichtlich, daß bei einer aktivierten ersten Schaltschwelle S₁ eine längere Vorlaufzeit T_{VL1} zur Verfügung steht als bei Aktivierung der zweiten, höheren Schwelle S₂. Durch die Aktivierung der zweiten Schwelle S₂ verringert sich die Vorlaufzeit T_{VL2}, so daß es unter Umständen dazu kommen kann, daß das Türschloß 2 noch nicht vollständig entriegelt ist, wenn die Hand 14 des berechtigten Benutzers bereits den Türgriff 4 erreicht hat. Diese u. U. auftretende Einschränkung hinsichtlich des Benutzerkomforts kann jedoch im Vergleich zu den Nachteilen einer zu häufigen Aktivierung des Identifikationsnehmers 12 leicht in Kauf genommen werden.

Damit dennoch die Vorlaufzeit T_{VL} nicht unnötiger Weise verkürzt wird, ist durch den erfindungsgemäßen kapazitiven Näherungsschalter 3 auch eine Erkennung des Regenendes möglich. Dies wird zunächst dadurch erreicht, daß auch bei aktivierter Schaltschwelle S₂, der Meßwert stets mit der Schaltschwell S₁ verglichen wird.

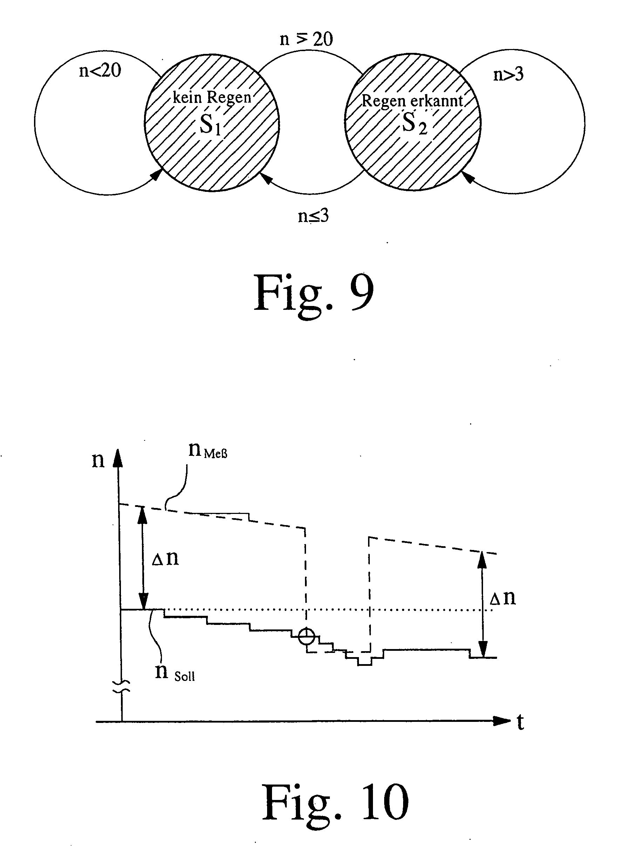

Die bei dem kapazitiven Näherungsschalter 3 vorzugsweise realisierte Regenerkennung sowie die beim Umschalten zwischen den beiden Schaltschwellen S₁ und S₂ realisierte Hysterese wird nachfolgend anhand des in Fig. 9 dargestellten Ablaufschemas erläutert.

Als Zeitdauer T₁, innerhalb der die Anzahl N der Kapazitätsänderungen ΔC₁ erfaßt wird, die größer als die Schaltschwelle S₁ sind, sind dabei beispielhaft zwei Minuten angenommen worden. Selbstverständlich kann jedoch auch eine kürzere oder längere Zeitdauer T₁, vorzugsweise zwischen 30 Sekunden und 3 Minuten eingestellt werden. Ist die Anzahl N der innerhalb von zwei Minuten registrierten Kapazitätsänderungen ΔC₁ größer als zwanzig, so wird dies von der Auswerteeinheit 7 als Regen interpretier, woraufhin dann die zweite Schaltschwelle S₂ als für den Schaltausgang 9 relevante Schaltschwelle aktiviert wird. Solange die Anzahl N der Kapazitätsänderungen ΔC₁ innerhalb von zwei Minuten größer als drei ist, solange bleibt die zweite Schaltschwelle S₂ für den Schaltausgang 9 aktiviert. Ist die Anzeige N dagegen nicht mehr größer als drei, so wird dies von der Auswerteeinheit 7 als Regenende interpretiert und wieder die erste Schaltschwelle S₁ als auch für den Schaltausgang 9 relevante Schaltschwelle aktiviert. Steigt die Anzahl N anschließt wieder auf zwanzig, wird dies von der Auswerteeinheit 7 wieder als Regen interpretiert und entsprechend erneut die zweite Schaltschwelle S₂ aktiviert.

Fig. 10 zeigt schließlich ein Zeitdiagramm zur Darstellung der Driftkorrektur, wobei die Schaltschwelle bei einer Änderung der Istkapazität C_{Ist} nachgeführt wird. Dies führt dazu, daß auch bei einer durch eine Temperaturänderung hervorgerufenen Änderung der Istkapazität C_{Ist} weiterhin dieselbe Kapazitätsänderung ΔC bzw. dieselbe Anzahlsänderung Δn erforderlich ist, um ein Schaltsignal zu erzeugen. Die relativ langsame Veränderung der Istkapazität C_{Ist} ist dabei nicht durch das Eintreten von Objekten in den sensitiven Bereich des Näherungsschalters 3 verursacht, sondern aufgrund anderer sich verändernder Umgebungsbedingungen. Die hierbei vorgenommene Änderung der Schaltschwelle ist dabei wesentlich geringer als die erforderliche Anzahlsänderung Δn₁ zur Erzeugung eines Schaltsignals. Beträgt die erste Schaltschwelle S₁, bei der eine Kapazitätsänderung ΔC₁ vorliegt, beispielsweise n₁ = 2450 und die Anzahlsänderung Δn₁ = 50, so erfolgt die Driftkorrektur in der Größenordnung von Δn_{Drift} = 5 - 10.

## Patentansprüche

1. Kapazitiver Näherungsschalter, zur Erfassung einer Kapazitätsänderung (ΔC) relativ zu einer Sollkapazität (Cₛₒₗₗ) durch die Annäherung oder Entfemung eines Objekts im sensitiven Bereich des Näherungsschalters (3), insbesondere zur Verwendung bei einem Türgriff (4) eines Kraftfahrzeuges (1), mit einem mindestens eine Ansprechelektrode (5) aufweisenden Elektrodensystem, mit einer Auswerteeinheit (7) und mit einem Schaltausgang (9), wobei die Auswerteeinheit derart ausgebildet ist, dass ein der Kapazitätsänderung (ΔC) entsprechender Meßwert mit einer ersten Schaltschwelle (S₁) verglichen wird, wobei am Schaltaussang (9) in Abhängigkeit vom Meßwert ein Schaltsignal erzeugt wird, wobei in der Auswerteeinheit (7) eine Auswertung des zeitlichen Verlaufs des der Kapazitätsänderung (ΔC) entsprechenden Meßwertes erfolgt, in Abhängigkeit vom zeitlichen Verlauf des Meßwertes eine zweite Schaltschwelle (S₂) aktiviert wird, wobei die zweite Schaltschwelle (S₂) nur bei einer relativ großen Kapazitätsänderung (ΔC₂) erreicht wird, die von einem in den sensitiven Bereich des Näherungsschalters (3) ein- oder austretenden Sollobjekt hervorgerufen wird, während die erste Schaltschwelle (S₁) auch bei einer kleineren Kapazitätsänderung (ΔC₁) erreicht wird, die auch von einem in den sensitiven Bereich des Näherungsschalters (3) ein- oder austretenden Fehlobjekt hervorgerufen werden kann, und in einem Normalzustand, bei dem die zweite Schaltschwelle (S₂) nicht aktiviert ist, dann ein Schaltsignal erzeugt wird, wenn der Meßwert die erste Schaltschwelle (S₁) erreicht hat, während bei aktivierter zweiten Schaltschwelle (S₂) nur dann ein Schaltsignal erzeugt wird, wenn der Meßwert die zweite Schaltschwelle (S₂) erreicht hat, und wobei die Ausgestaltung der Auswerteeinheit **dadurch gekennzeichnet ist, dass** auch dann, wenn das Schaltsignal am Schaltausgang (9) durch die zweite Schaltschwelle (S₂) bestimmt wird, der Meßwert stets auch mit der ersten Schaltschwelle (S₁) verglichen wird.

2. Kapazitiver Näherungsschalter nach Anspruch 1, **dadurch gekennzeichnet, daß** die Auswerteeinheit (7) einen Speicher (16) aufweist und nach Erreichen der ersten Schaltschwelle (S₁) der Meßwert noch für eine bestimmt Zeitdauer fortlaufend ermittelt und gespeichert wird.

3. Kapazitiver Näherungsschalter nach Anspruch 1 oder 2, **dadurch gekennzeichnet, daß** die zeitliche Auswertung des Meßwertes anhand eines Vergleichs des zeitlichen Verlaufs des Meßwertes mit in dem Speicher (16) abgelegten Signalverläufen erfolgt.

4. Kapazitiver Näherungsschalter nach Anspruch 1, **dadurch gekennzeichnet, daß** die Auswerteeinheit (7) einen Zähler (17) aufweist, wobei von dem Zähler (17) die Anzahl N der Kapazitätsänderungen ΔC pro Zeitdauer T₁ erfaßt wird, die größer als die erste Schaltschwelle S₁ sind (Kapazitätsänderungen ΔC₁) und wobei die zweite Schaltschwelle S₂ dann aktiviert wird, wenn die Anzahl N einen Grenzwert G₁ übersteigt.

5. Kapazitiver Näherungsschalter nach Anspruch 4, **dadurch gekennzeichnet, daß** bei aktivierter zweiten Schaltschwelle S₂ dann wieder die erste Schaltschwelle S₁ aktiviert wird, wenn die Anzahl N der Kapazitätsänderung ΔC₁ pro Zeitdauer T₂ unter einen Grenzwert G₂ fällt.

6. Kapazitiver Näherungsschalter nach Anspruch 5, **dadurch gekennzeichnet, daß** durch eine entsprechende Wahl der Grenzwerte G₁, G₂ eine Hysterese für das Umschalten zwischen den beiden Schaltschwellen S₁, S₂ realisiert ist.

7. Kapazitiver Näherungsschalter nach Anspruch 5 oder 6, **dadurch gekennzeichnet, daß** die Zeitdauer T₁ während der vom Zähler (8) die Anzahl N der Kapazitätsänderung ΔC₁ erfaßt wird geringer ist als die Zeitdauer T₂ während der vom Zähler (17) bei aktivierter zweiter Schaltschwelle S₂ die Anzahl N der Kapazitätsänderung ΔC₁ erfaßt wird.

8. Kapazitiver Näherungsschalter nach einem der Ansprüche 5 bis 7, **dadurch gekennzeichnet, daß** die Schaltschwellen S₁, S₂ und/oder die Grenzwerte G₁, G₂ und/oder die Zeitdauer T₁, T₂ einstellbar sind.

9. Kapazitiver Näherungsschalter nach einem der Ansprüche 1 bis 8, **dadurch gekennzeichnet, daß** mehr als zwei Schaltschwellen vorgesehen sind.

10. Kapazitiver Näherungsschalter nach einem der Ansprüche 5 bis 9, **dadurch gekennzeichnet, daß** mehr als zwei Zeitdauern vorgesehen sind.

11. Kapazitiver Näherungsschalter nach einem der Ansprüche 1 bis 10, **dadurch gekennzeichnet, daß** die Schaltschwellen S₁, S₂ dynamisch bei einer Änderung der gemessenen Istkapazität C_{Ist} nachgeführt werden, so daß eine Driftkorrektur realisiert ist.

12. Kapazitiver Näherungsschalter nach einem der Ansprüche 1 bis 11, **dadurch gekennzeichnet, daß** die Geschwindigkeit der Kapazitätsänderung ΔC/Δt gemessen wird und daß Kapazitätsänderungen ΔC, die eine Geschwindigkeit kleiner als eine untere Grenzgeschwindigkeit vᵤ aufweisen, unterdrückt werden.

13. Kapazitiver Näherungsschalter nach Anspruch 12, **dadurch gekennzeichnet, daß** in dem Speicher (16) mindestens zwei Grenzgeschwindigkeiten v₁, v₂ gespeichert sind und daß eine gemessene Kapazitätsänderung ΔC die größer als die aktivierte Schaltschwelle S₁, S₂ ist, nur dann eine Aktivierung des Schaltausgangs (9) bewirkt, wenn die Geschwindigkeit der gemessenen Kapazitätsänderung ΔC/Δt größer als die untere Grenzgeschwindigkeit v₁ und/oder kleiner als die obere Grenzgeschwindigkeit v₂ ist.

14. Kapazitiver Näherungsschalter nach einem der Ansprüche 5 bis 13, **dadurch gekennzeichnet, daß** innerhalb einer Einlernphase (Teach-In) aufgrund der zeitlichen Auswertung der Kapazitätsänderung ΔC bzw. des Meßwertes von der Auswerteeinheit (7) bzw. einem zu der Auswerteeinheit gehörenden Mikroprozessor die Schaltschwellen S₁, S₂, die Grenzwerte G₁, G₂ und/oder die Zeitdaueren T₁, T₂ einstellbar sind.

15. Schaltungsanordnung zum Ent- oder Verriegeln mindestens eines Türschlosses (2) eines Kraftfahrzeugs (1), mit einer elektronischen Aktivierungsschaltung (12, 13) und mit einem kapazitiven Näherungsschalter (3), nach einem der Ansprüche 1 bis 14, wobei die Ansprechelektrode (5) des kapazitiven Näherungsschalters (3) in dem Türgriff (4) integriert ist,
**dadurch gekennzeichnet,**
**daß** die Entriegelung oder die Verriegelung des Türschlosses (2) nur dann erfolgt, wenn von einer in den sensitiven Bereich des Näherungsschalters (3) ein- oder austretenden Hand (14) einer Person eine Kapazitätsänderung ΔC hervorgerufen wird, die einen Meßwert erzeugt, der größere als die aktivierte Schaltschwelle S₁, S₂ ist, so daß am Schaltausgang (9) des kapazitiven Näherungsschalters (3) ein Schaltsignal anliegt und
wenn ausgelöst durch das Schaltsignal des kapazitiven Näherungsschalters (3) von der elektronischen Aktivierungsschaltung (12, 13) die Person als berechtigte Person erkannt worden ist.

16. Schaltungsanordnung nach Anspruch 15, mit einem kapazitiven Näherungsschalter nach einem der Ansprüche 8 bis 14, **dadurch gekennzeichnet, daß** den Schaltschwellen S₁, S₂ und/oder den Grenzwerten G₁, G₂ und/oder den Zeitdauern T₁, T₂ in Abhängigkeit davon unterschiedliche Werte zugewiesen werden, ob das Türschloß (2) entriegelt oder verriegelt ist.

17. Schaltungsanordnung nach Anspruch 15, mit einem kapazitiven Näherungsschalter nach Anspruch 13, **dadurch gekennzeichnet, daß** den Grenzgeschwindigkeiten v₁, v₂ in Abhängigkeit davon unterschiedliche Werte zugewiesen werden, ob das Türschloß (2) entriegelt oder verriegelt ist.

18. Schaltungsanordnung nach einem der Ansprüche 15 bis 17, **dadurch gekennzeichnet, daß** ein zweiter Sensor, insbesondere ein zweiter kapazitiver Näherungsschalter, vorgesehen ist, der als Regensensor fungiert und vorzugsweise darüber hinaus auch das Schaltsignal zum Verriegeln des Türschlosses (2) liefert, während der erste kapazitive Näherungsschalter (3) nur das Schaltsignal zum Entriegeln des Türschlosses (2) liefert.

## Claims

1. Capacitive proximity switch for detecting a capacitance change ΔC relative to a desired capacitance (C_{Soll}) as a result of an object approaching or moving away from the sensitive area of the proximity switch (3), in particular for use in a door handle (4) of a motor vehicle (1),
having an electrode system which has at least one response electrode (5), having an evaluation unit (7) and having a switching output (9),
the evaluation unit (7) being designed in such a manner that a measured value corresponding to the capacitance change (ΔC) is compared with a first switching threshold (S₁),
a switching signal being generated at the switching output (9) on the basis of the measured value,
the temporal profile of the measured value corresponding to the capacitance change (ΔC) being evaluated in the evaluation unit (7),
a second switching threshold (S₂) being activated on the basis of the temporal profile of the measured value, the second switching threshold (S₂) being reached only in the case of a relatively large capacitance change (ΔC₂) caused by a desired object entering or exiting the sensitive area of the proximity switch (3), whereas the first switching threshold (S₁) is reached even in the case of a relatively small capacitance change (ΔC₁) which can also be caused by an incorrect object entering or exiting the sensitive area of the proximity switch (3), and
in a normal state in which the switching threshold (S₂) is not activated, a switching signal being generated when the measured value has reached the first switching threshold (S₁), whereas, when the second switching threshold (S₂) is activated, a switching signal is generated only when the measured value has reached the second switching threshold (S₂), and the configuration of the evaluation unit (7)
being **characterized in that**
the measured value is always also compared with the first switching threshold (S₁) even when the switching signal at the switching output (9) is determined by the second switching threshold (S₂).

2. Capacitive proximity switch according to Claim 1, **characterized in that** the evaluation unit (7) has a memory (16), and the measured value is also continuously determined and stored for a particular period after the first switching threshold (S₁) has been reached.

3. Capacitive proximity switch according to Claim 1 or 2, **characterized in that** the measured value is temporally evaluated by comparing the temporal profile of the measured value with signal profiles stored in the memory (16).

4. Capacitive proximity switch according to Claim 1, **characterized in that** the evaluation unit (7) has a counter (17), the counter (17) detecting the number N of capacitance changes ΔC per period T₁ which are greater than the first switching threshold S₁ (capacitance changes ΔC₁), and the second switching threshold S₂ being activated when the number N exceeds a limit value G₁.

5. Capacitive proximity switch according to Claim 4, **characterized in that**, when the second switching threshold S₂ is activated, the first switching threshold S₁ is activated again when the number N of capacitance changes ΔC₁ per period T₂ falls below a limit value G₂.

6. Capacitive proximity switch according to Claim 5, **characterized in that** hysteresis for changing over between the two switching thresholds S₁, S₂ is achieved by appropriately selecting the limit values G₁, G₂.

7. Capacitive proximity switch according to Claim 5 or 6, **characterized in that** the period T₁ during which the counter (8) detects the number N of capacitance changes ΔC₁ is shorter than the period T₂ during which the counter (17) detects the number N of capacitance changes ΔC₁ when the second switching threshold S₂ is activated.

8. Capacitive proximity switch according to one of Claims 5 to 7, **characterized in that** the switching thresholds S₁, S₂ and/or the limit values G₁, G₂ and/or the periods T₁, T₂ can be adjusted.

9. Capacitive proximity switch according to one of Claims 1 to 8, **characterized in that** more than two switching thresholds are provided.

10. Capacitive proximity switch according to one of Claims 5 to 9, **characterized in that** more than two periods are provided.

11. Capacitive proximity switch according to one of Claims 1 to 10, **characterized in that** the switching thresholds S₁, S₂ are dynamically connected when the measured actual capacitance C_{Ist} changes, with the result that drift correction is implemented.

12. Capacitive proximity switch according to one of Claims 1 to 11, **characterized in that** the speed of the capacitance change ΔC/Δt is measured, and **in that** capacitance changes ΔC which have a speed less than a lower limit speed vᵤ are suppressed.

13. Capacitive proximity switch according to Claim 12, **characterized in that** at least two limit speeds v₁, v₂ are stored in the memory (16), and **in that** a measured capacitance change ΔC which is greater than the activated switching threshold S₁, S₂ activates the switching output (9) only when the speed of the measured capacitance change ΔC/Δt is greater than the lower limit speed v₁ and/or less than the upper limit speed v₂.

14. Capacitive proximity switch according to one of Claims 5 to 13, **characterized in that** the switching thresholds S₁, S₂, the limit values G₁, G₂ and/or the periods T₁, T₂ can be adjusted within a teach-in phase on the basis of the temporal evaluation of the capacitance change ΔC or the measured value by the evaluation unit (7) or a microprocessor belonging to the evaluation unit.

15. Circuit arrangement for unlocking or locking at least one door lock (2) of a motor vehicle (1), having an electronic activation circuit (12, 13) and having a capacitive proximity switch (3) according to one of Claims 1 to 14, the response electrode (5) of the capacitive proximity switch (3) being integrated in the door handle (4),
**characterized in that**
the door lock (2) is unlocked or locked only when a person's hand (14) entering or exiting the sensitive area of the proximity switch (3) causes a capacitance change ΔC which produces a measured value which is greater than the activated switching threshold S₁, S₂, with the result that a switching signal is applied to the switching output (9) of the capacitive proximity switch (3), and
if triggered by the switching signal from the capacitive proximity switch (3), the electronic activation circuit (12, 13) has identified the person as an authorized person.

16. Circuit arrangement according to Claim 15, having a capacitive proximity switch according to one of Claims 8 to 14, **characterized in that** different values are allocated to the switching thresholds S₁, S₂ and/or the limit values G₁, G₂ and/or the periods T₁, T₂ depending on whether the door lock (2) is unlocked or locked.

17. Circuit arrangement according to Claim 15, having a capacitive proximity switch according to Claim 13, **characterized in that** different values are allocated to the limit speeds v₁, v₂ on the basis of whether the door lock (2) is unlocked or locked.

18. Circuit arrangement according to one of Claims 15 to 17, **characterized in that** a second sensor, in particular a second capacitive proximity switch, is provided, which sensor acts as a rain sensor and preferably also provides the switching signal for locking the door lock (2), while the first capacitive proximity switch (3) provides only the switching signal for unlocking the door lock (2).

## Revendications

1. Détecteur de proximité capacitif destiné à détecter un changement de capacité ΔC par rapport à une capacité de consigne (C_{Soll}) par approche ou éloignement d'un objet dans la zone sensible du détecteur de proximité (3), notamment destiné à être utilisé avec une poignée de portière (4) d'un véhicule automobile(1), comprenant un système d'électrodes qui présente au moins une électrode de réaction (5), comprenant une unité d'interprétation (7) et comprenant une sortie commutée (9), l'unité d'interprétation (7) étant configurée de telle sorte qu'une valeur mesurée correspondant au changement de capacité (ΔC) est comparée avec un premier seuil de commutation (S₁),
un signal de commutation étant généré au niveau de la sortie commutée (9) en fonction de la valeur mesurée,
une interprétation de l'évolution dans le temps de la valeur mesurée correspondant au changement de capacité (ΔC) est effectuée dans l'unité d'interprétation (7),
un deuxième seuil de commutation (S₂) est activé en fonction de l'évolution dans le temps de la valeur mesurée, le deuxième seuil de commutation (S₂) n'étant atteint que dans le cas d'un changement de capacité (ΔC₂) relativement important, lequel est provoqué par un objet voulu entrant dans la zone sensible du détecteur de proximité (3) ou en sortant, alors que le premier seuil de commutation (S₁) est également atteint dans le cas d'un faible changement de capacité (ΔC₁), lequel peut également être provoqué par un objet parasite entrant dans la zone sensible du détecteur de proximité (3) ou en sortant, et
dans un état normal, dans lequel le deuxième seuil de commutation (S₂) n'est pas activé, un signal de commutation est généré lorsque la valeur mesurée a atteint le premier seuil de commutation (S₁), alors que lorsque le deuxième seuil de commutation (S₂) est activé, un signal de commutation n'est généré que lorsque la valeur mesurée a atteint le deuxième seuil de commutation (S₂),
et la configuration de l'unité d'interprétation (7) étant **caractérisée en ce que** même lorsque le signal de commutation à la sortie commutée (9) est déterminé par le deuxième seuil de commutation (S₂), la valeur mesurée est toujours comparée aussi avec le premier seuil de commutation (S₁).

2. Détecteur de proximité capacitif selon la revendication 1, **caractérisé en ce que** l'unité d'interprétation (7) présente une mémoire (16) et après avoir atteint le premier seuil de commutation (S₁), la valeur mesurée est encore déterminée continuellement et mise en mémoire pendant une unités de temps donnée.

3. Détecteur de proximité capacitif selon la revendication 1 ou 2, **caractérisé en ce que** l'interprétation dans le temps de la valeur mesurée est effectuée à l'aide d'une comparaison de l'évolution dans le temps de la valeur mesurée avec des courbes de signal enregistrées dans la mémoire (16).

4. Détecteur de proximité capacitif selon la revendication 1, **caractérisé en ce que** l'unité d'interprétation (7) présente un compteur (17), le compteur (17) faisant l'acquisition du nombre N de changements de capacité ΔC par unité de temps T₁ qui sont supérieurs au premier seuil S₁ (changements de capacité ΔC₁) et le deuxième seuil de commutation S₂ étant activé lorsque le nombre N dépasse une valeur limite G₁.

5. Détecteur de proximité capacitif selon la revendication 4, **caractérisé en ce que** lorsque le deuxième seuil de commutation S₂ est activé, le premier seuil de commutation S₁ est de nouveau activé lorsque le nombre N de changements de capacité ΔC₁ par unité de temps T₂ devient inférieur à une valeur limite G₂.

6. Détecteur de proximité capacitif selon la revendication 5, **caractérisé en ce qu'**une hystérésis pour la permutation entre les deux seuils de commutation S₁, S₂ est réalisée par une sélection en conséquence des valeurs limites G₁, G₂.

7. Détecteur de proximité capacitif selon la revendication 5 ou 6, **caractérisé en ce que** l'unités de temps T₁ pendant laquelle le compteur (8) effectue l'acquisition du nombre N de changements de capacité ΔC₁ est inférieure à l'unités de temps T₂ pendant laquelle le compteur (17), lorsque le deuxième seuil de commutation S₂ est activé, effectue l'acquisition du nombre N de changements de capacité ΔC₁.

8. Détecteur de proximité capacitif selon l'une des revendications 5 à 7, **caractérisé en ce que** les seuils de commutation S₁, S₂ et/ou les valeurs limites G₁, G₂ et/ou les unités de temps T₁, T₂ sont réglables.

9. Détecteur de proximité capacitif selon l'une des revendications 1 à 8, **caractérisé en ce que** plus de deux seuils de commutation sont prévus.

10. Détecteur de proximité capacitif selon l'une des revendications 5 à 9, **caractérisé en ce que** plus de deux unités de temps sont prévues.

11. Détecteur de proximité capacitif selon l'une des revendications 1 à 10, **caractérisé en ce que** les seuils de commutation S₁, S₂ sont asservis dynamiquement lors d'une modification de la capacité réelle C_{Ist} mesurée, réalisant ainsi une correction de la dérive.

12. Détecteur de proximité capacitif selon l'une des revendications 1 à 11, **caractérisé en ce que** la vitesse du changement de capacité ΔC/Δt est mesurée et **en ce que** les changements de capacité ΔC qui présentent une vitesse inférieure à une vitesse limite inférieure Vᵤ sont inhibés.

13. Détecteur de proximité capacitif selon la revendication 12, **caractérisé en ce qu'**au moins deux vitesses limites v₁, v₂ sont enregistrées dans la mémoire (16) et **en ce qu'**un changement de capacité ΔC mesuré qui est supérieur au seuil de commutation S₁, S₂ activé ne provoque une activation de la sortie commutée (9) que lorsque la vitesse du changement de capacité mesuré ΔC/Δt est supérieure à la vitesse limite inférieure v₁ et/ou inférieure à la vitesse limite supérieure v₂.

14. Détecteur de proximité capacitif selon l'une des revendications 5 à 13, **caractérisé en ce que** les seuils de commutation S₁, S₂, les valeurs limites G₁, G₂ et/ou les unités de temps T₁, T₂ sont réglables à l'intérieur d'une phase d'apprentissage (Teach-In) en se basant sur l'interprétation dans le temps du changement de capacité ΔC ou de la valeur mesurée par l'unité d'interprétation (7) ou d'un microprocesseur faisant partie de l'unité d'interprétation.

15. Arrangement de circuit pour déverrouiller ou verrouiller au moins une serrure de portière (2) d'un véhicule automobile (1), comprenant un circuit d'activation électronique (12, 13) et comprenant un détecteur de proximité capacitif (3) selon l'une des revendications 1 à 14, l'électrode de réaction (5) du détecteur de proximité capacitif (3) étant intégrée dans la poignée de portière (4),
**caractérisé en ce**
**que** le déverrouillage ou le verrouillage de la serrure de portière (2) n'a lieu que lorsqu'une main (14) d'une personne qui entre dans la zone sensible du détecteur de proximité (3) ou qui en sort provoque un changement de capacité ΔC qui produit une valeur mesurée supérieure au seuil de commutation S₁, S₂ activé, de sorte qu'un signal de commutation est présent à la sortie commutée (9) du détecteur de proximité capacitif (3), et
lors d'un déclenchement par le signal de commutation du détecteur de proximité capacitif (3), la personne est reconnue comme une personne autorisée par le circuit d'activation électronique (12, 13).

16. Arrangement de circuit selon la revendication 15, comprenant un détecteur de proximité capacitif selon l'une des revendications 8 à 14, **caractérisé en ce que** des valeurs différentes sont affectées aux seuils de commutation S₁, S₂ et/ou aux valeurs limites G₁, G₂ et/ou aux unités de temps T₁, T₂, suivant que la serrure de portière (2) est déverrouillée ou verrouillée.

17. Arrangement de circuit selon la revendication 15, comprenant un détecteur de proximité capacitif selon la revendication 13, **caractérisé en ce que** des valeurs différentes sont affectées aux vitesses limites V₁, V₂, suivant que la serrure de portière (2) est déverrouillée ou verrouillée.

18. Arrangement de circuit selon l'une des revendication 15 à 17, **caractérisé en ce qu'**il est prévu un deuxième capteur, notamment un deuxième détecteur de proximité capacitif, lequel fait office de détecteur de pluie et, en plus de cela, délivre également de préférence le signal de commutation pour verrouiller la serrure de portière (2), alors que le premier détecteur de proximité capacitif (3) ne délivre que le signal de commutation pour le déverrouillage de la serrure de portière (2).
